# EUROPEAN PATENT APPLICATION

(11) **EP 1 615 489 A2**
(43) Date of publication of application: **11.01.2006**
(21) Application number: 05106237.0
(22) Date of filing: 08.07.2005
(51) Int. Cl.: H05K 13/00

(54) **Modular gripper**

(30) Priority: 09.07.2004 FI 20040957; 09.07.2004 FI 20040273 U
(71) Applicant: IT-LINE OY, 24910 Halikko as. (FI)
(72) Inventor: Äikäs, Pertti, 25460 Kisko (FI)
(74) Representative: Suominen, Kaisa Liisa

(57) **Abstract**

A structurally modifiable gripper for handling circuit boards or similar boards, which gripper comprises a connecting adapter (2) for fixing the gripper to an actuator, such as a robot, a frame part (1), at least one connecting part (3) and at least one gripping element (6). To a first groove (4) located in the frame part of the gripper has been movably arranged a connecting adapter for connecting the gripper to an actuator and to a second groove (5) located in the frame part has been further arranged at least one connecting part for fixing at least one gripping element. The invention also relates to a method for fixing the gripper to the frame part of the gripper.

## Description

### Field of the invention

The object of the present invention is a gripper and a method according to the preambles of the independent claims.

### BACKGROUND OF THE INVENTION

In automation devices various grippers are used for handling circuit boards or similar boards. Grippers are used for example for conveying, loading and performing test phases of circuit boards during production processes. The physical size and gripping mode of a gripper varies according to the size and structure of a circuit board, due to which the gripper is generally product-specific. Such gripper has to be designed and manufactured specifically for each product.

Replacing a gripper designed for a product afterwards with another product is difficult, because the mechanical structure of the gripper is not usually designed for reuse. Further, the reutilization of structures of a gripper is poor, because usually only actuators to be fixed to the gripper can be reused. The structure of the grippers is usually such, that their adjustment in respect of the products of different size or different form to be gripped is difficult or there is no adjustment possibility. This is the reason, why grippers have to be replaced during production processes upon changing the product batches.

The patent publication FI 105315 discloses a typical servomotor controlled gripper. The disadvantage of adjustable grippers provided with motor is their high number of components and complexity, what makes grippers expensive. Further, the use of grippers is limited by the requirements set for the motor control, for example the control mode of the motor, due to which a motor controlled gripper is generally tied to an actuator to be used.

The patent publication US 5,680,936 discloses another typical gripper. The gripper disclosed in the publication is poorly replaceable for products of different size. The disadvantage of such grippers is besides their product-specificity the fact that they lack connecting means. Thus, grippers cannot be mounted to other actuators to be used, such as robot cells. Therefore, the solution of such grippers is not only expensive, but unsatisfactory as well.

### SUMMARY OF THE INVENTION

The aim of the present invention is to solve above-mentioned problems and to provide a structurally modular gripper, which can be used for gripping to different products, such as circuit boards or similar parts.

In order to attain the aims of the invention the gripper according to the invention is characterised by what is defined in the characterising parts of the independent claims presented below. Some advantageous embodiments of the invention are presented in the dependent claims.

A typical gripper according to the invention for handling circuit boards or similar boards comprises a connecting adapter for fixing the gripper to an actuator, a frame part, at least one connecting part and at least one gripping element. The actuator can be for example a robot. The gripper is characterized in that the frame part further comprises at least one first groove extending from one end of the frame part to its other opposite end for guiding the connecting adapter between the ends of the frame part and for fixing it to its place, and at least one second groove parallel with the first groove and for guiding at least one connecting part and at least one gripping element arranged thereto between the ends of the frame part and for fixing at least one connecting part to its place. By gripping elements are meant for example cylinders, electric linear actuators or under pressure elements, which are used for gripping the product, for example a circuit board. The gripping elements are fixed to the frame part by means of connecting parts. The diameter of a typical connecting part is in the range of 50-100 mm, preferably 75 mm, and its height is in the range of 20-60 mm, preferably 40 mm. Typically, the connecting part is manufactured of metal, for example of aluminium. The length and width of the connecting adapter of a typical gripper according to the invention can be in the range of 30-38 mm, for example 32 mm or 36 mm, and its height in the range of 3-30 mm, for example 5 mm. A typical connecting adapter is manufactured of metal, for example of aluminium.

The grooves arranged to the frame part of a typical gripper of the invention are used for moving the connecting parts and connecting adapter in the frame part. Since the grooves extend from one end of the frame part to its other end, the frame part can be provided with additional connecting parts without needing to demount other connecting parts fixed to the frame. Typically, the grooves extending over the frame part are arranged so that they begin from one end of the frame part and end to the other opposite end of the frame part. If the frame part has an elongated form, its grooves typically run to the longitudinal direction of the frame part. These grooves enable the fact, that the adjustability of the connecting parts and connecting adapter to be fixed to the frame part of the gripper is as high as possible in the direction of the grooves. The number of the first grooves can be for example 1, 2, 3, 4, 5 or 6. The number of the second grooves can be for example 1, 2, 3, 4, 5 or 6. The number of the first and seconds grooves can be the same or different. The width of said grooves is for example in the range of 3-6 mm, preferably 5 mm. The length of said grooves can be equal to the length of the frame part, which is, for example, in the range of 150-250 mm, preferably 200 mm.

Gripping elements can be fixed to the connecting parts of a typical gripper according to the invention so that different products can also simultaneously be gripped with one gripper. The adjustment of the distance between the gripper elements is possible in the direction of the grooves, what improves the usability of the gripper. When the dimensioning of the product to be gripped changes, the gripper elements used in the gripper need typically not be replaced, but the readjustment of the distance between the elements will be sufficient. Thus, the most significant advantage of the invention is, that with it is accomplished a structurally simple and modular gripper, which can be modified according to the purpose of use.

The invention further relates to a method for fixing the connecting part of the gripper, with which gripper it is intended to grip circuit boards or similar boards, to the frame part of the gripper, in which method the connecting part is positioned to the desired place of the frame part and the connecting part is fixed to the frame part by fixing means.

According to an embodiment of the invention at least one first groove is located at the opposite side of the frame part in relation to the at least one second groove of the frame part. Thus, the connecting adapter of the gripper can be arranged to be fixed in relation to the frame part to the opposite side of the connecting parts. If the connecting adapter is arranged above the frame part, gripping of the product or object to be gripped can be achieved and the center of gravity can be arranged directly under the connecting adapter and the frame part. Herewith is additionally achieved the advantage, that the loading can be distributed to the frame part of the gripper in a manner chosen by the user.

According to an embodiment of the invention the connecting adapter has been arranged to the first groove of the frame part so that the connecting adapter has been arranged to be moved in the first groove from one end of the frame part to its other opposite end. Thus, the position of the connecting part can be changed between the ends of the first groove of the frame part.

According to an embodiment of the invention the gripper comprises at least one connecting part, which has been arranged to the second groove of the frame part so that the connecting part has been arranged to be moved in the second groove from one end of the frame part to its other opposite end. Thus, the position of the connecting part can be changed between the ends of the second groove of the frame part. The exact position of the connecting part in the frame part is determined by moving the connecting part in the direction of the second groove to the desired place.

According to an embodiment of the invention the gripper comprises at least two connecting parts, which have been arranged to the same second groove of the frame part so that the connecting parts have been arranged to be moved in the same second groove irrespective of each other. If there are several connecting parts, e.g. three or four, they are arranged movably to the same second groove one after the other. Connecting parts can thus be moved in the groove exactly to the desired places between the ends of the frame part and/or the connecting parts arranged to the frame part. The connecting parts can be fixed to the frame part by fixing means. Therefore, the distances between the connecting parts can vary in the frame part according to the purpose of use of the gripper.

According to an embodiment of the invention, to the said frame part has been arranged a cable trunking, which extends from one end of the frame part to its other opposite end. The cable trunking can be parallel with the grooves of the frame part. The cable trunking can be provided with a demountable lid, thereby enabling the protection and support of the wiring of the gripper during the operation of the gripper. The length of the cable trunking can vary, for example, in the range of 50-300 mm. The length of the cable trunking is preferably for example 200 mm. The height and width of the cable trunking are for example in the range of 10-20 mm, the height and width are preferably 16 mm. The cable trunking has been manufactured for example of plastic.

According to an embodiment of the invention the frame part is of aluminium profile. Thus, the frame part is quite lightweight and inexpensive. If the surface of the aluminium profile is convex or concave, it can easily be processed/machined flat before mounting the necessary components to it. A flat surface enables a more supporting and accurate mounting of connecting parts, gripping elements and other possible components, for example the mounting of a cylinder to the frame part of the gripper.

Other embodiments of the invention are disclosed in the characterising parts of the appended dependent claims.

### BRIEF DESCRIPTION OF THE FIGURES

In the following, the invention will be described in more detail with reference to the appended figures, in which
- Fig. 1 A: shows as an example an assembly view of the gripper according to the first embodiment of the invention,
- Fig. 1 B: shows as an example the same assembly view of the gripper according to the first embodiment of the invention seen from different direction,
- Fig. 2: shows as an example a gripper according to the second embodiment of the invention,
- Fig. 3: shows as an example a gripper according to the third embodiment of the invention,
- Fig. 4: shows as an example the same gripper according to the third embodiment of the invention seen from the end,
- Fig.5: shows as an example the same gripper according to the third embodiment of the invention seen from the side upon gripping the circuit board.

### DESCRIPTION OF OTHER EMBODIMENTS OF THE INVENTION

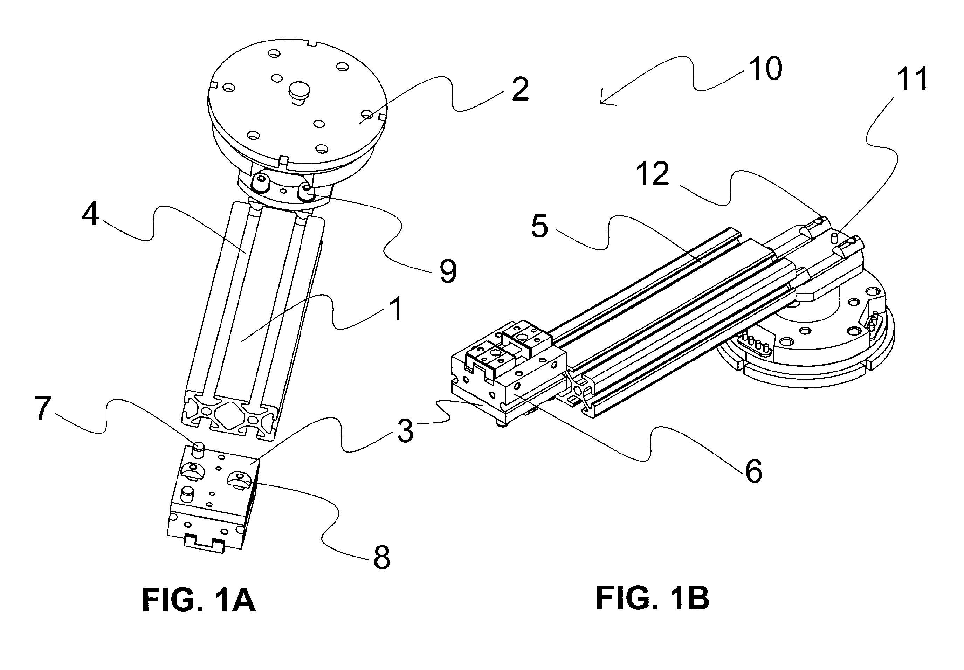

Fig 1A shows as an example an assembly view of the gripper according to the first embodiment of the invention. Fig 1 B shows as an example the same assembly view of the gripper according to the first embodiment of the invention. In Figs. 1 A and 1 B a longitudinal profile, which has a cross section of rectangular shape and which can be manufactured e.g. of aluminium, is used as an example as a frame part 1 of the gripper 10. A typical frame part 1 of the gripper has for example a length of 200 mm, a width of 40 mm and a height of 20 mm. The frame part 1 of the gripper 10 comprises two first grooves 4, shown in Fig. 1A, and two second grooves 5, shown in Fig. 1 B, which grooves 4, 5 are parallel and have a width for example of 5 mm, extending from one end of the frame part 1 to its other end. The shape of the first groove 4 and the second groove 5 is such, that it enables fixing and moving the connecting adapter and connecting parts. The connecting adapter 2 is brought from one end of the frame part 1 in direction of the first groove 4 of the frame part 1. To the connecting adapter has been arranged fixing means, for example screws 9 and nuts 12, with which the connecting adapter can be locked exactly to the desired place of the first groove 4 of the frame part. The fixing means 9, 12 have been dimensioned to match to the groove 4 of the frame part 1 so that the connecting adapter 2 can be moved in the groove 4 between the ends of the frame part, when the fixing means have been loosened. Fixing means, in this case a nut 12, arranged to the first groove 4, is advantageously of such shape, that it sets exactly against the inner surface of the groove.

To the connecting part 3 of Figs. 1 A and 1 B has been arranged a gripping element 6, which in this case is a cylinder. The cylinder is for example a precision guide cylinder, the diameter of which is for example 8 mm. The impact distance of the cylinder is for example 8 mm. The outer dimensions of the cylinder are here for example 36 mm x 32 mm x 18.5 mm. The cylinder has been fixed to the connecting part 3 with appropriate fixing means, for example a cylindrical pin (not shown in the Figs.). The connecting part 3 and the cylinder fixed thereto are brought to the frame part 1 from its one end in direction with the second groove 5. The diameter of the connecting part 3 is here 75 mm and the height is 40 mm measured from the frame part 1. To the connecting part 3 has been arranged fixing means 8, for example screws and nuts, with which the connecting part 3 can be locked exactly to the desired place to the second groove 5 of the frame part 1. The fixing means 8 have been dimensioned to match to the groove 5 of the frame part 1 so, that the connecting part 3 can be moved in the groove 5 between the ends of the frame part 1, when the fixing means have been loosened. The fixing means, in this case a nut 8, arranged to the second groove 5, is advantageously of such shape, that it sets exactly against the inner surface of the groove.

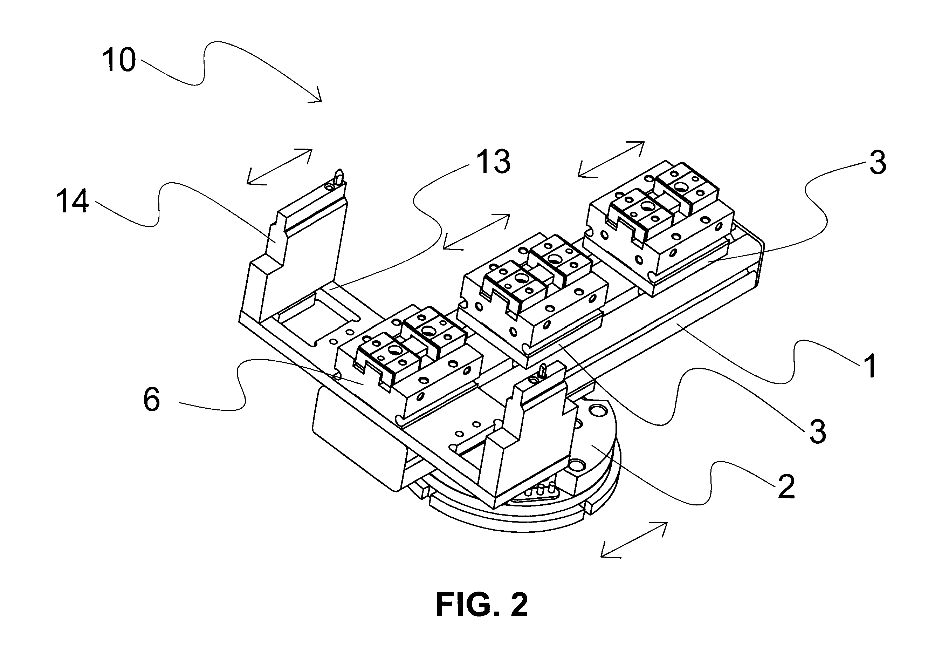

Fig. 2 shows as an example a gripper according to the second embodiment of the invention. A gripper 10 according to Fig. 2 can be in some respects similar than the gripper shown in Figs. 1A and 1 B. The gripper 10 according to Fig. 2 comprises a frame part 1, to the two first grooves located to which frame part has been arranged a connecting adapter 2 to be moved to the direction of the arrows between the ends of the frame part, wherein the connecting interface of which connecting adapter for a robot unit or a similar actuator is for example MA31 0 or MA210 quick change units manufactured by SMC Pneumatics Inc. The size of the connecting adapter 2 is here for example 36 mm x 32 mm x 5 mm. The connecting adapter can also be other kind of quick change unit for connecting to the actuator. To the two second grooves located in the frame part 1 of the gripper 10 have been further arranged connecting parts 3 to be moved to the direction of the arrows between the ends of the frame part. Furthermore, to the connecting parts have been arranged gripping elements 6, which in this case are cylinders. In Fig. 2 to the connecting part of the frame part 1 has been further arranged a fixing part 13 of the alignment elements, to both ends of which fixing part have been arranged alignment elements 14 for a mechanical alignment of the product. The length of the fixing part 13 of the alignment elements is here 118 mm, the height is 5 mm and the width is 36 mm. The material of the fixing part 13 of the alignment elements is metal, here for example aluminium. The width of the alignment elements 14 is 36 mm, the length is 41.5 mm and the height is 8 mm. The material of the alignment element 14 is metal, for example aluminium. In Fig. 2 the first grooves of the frame part 1 are located in relation to the second grooves of the frame part at the opposite side of the frame part and opposite to each other.

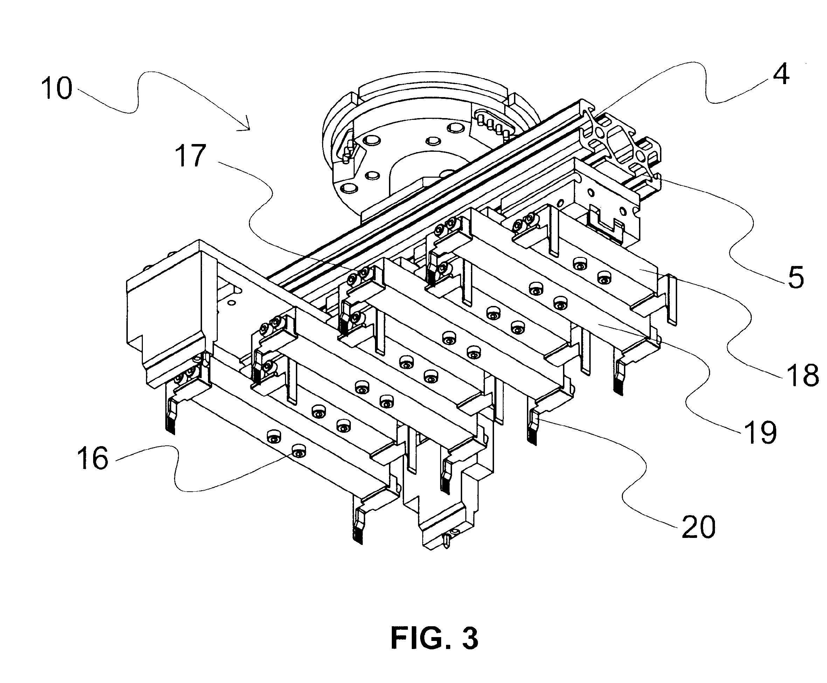

Fig. 3 shows as an example a gripper according to the third embodiment of the invention. A gripper 10 according to Fig. 3 can be in some respects similar than the gripper shown in Figs. 1 A, 1 B and 2. To the upper surface of the frame part 1 have been arranged two first grooves 4 to the longitudinal direction of the frame part. To the lower surface of the frame part 1 opposite to the upper surface, to the longitudinal direction of the frame part have been arranged two second grooves 5 parallel to the first groove and equally long with it, which grooves extend to the entire length of the frame part. A connecting adapter has been arranged to the first grooves 4 of the frame part 1. The connecting adapter can be moved in the frame part to the direction of the two first grooves 4, i.e. in this case to the longitudinal direction of the frame part 1. The connecting adapter has been fixed to the first groove 4 with appropriate screws and nuts. The connecting adapter 2 can be stationarily fixed to its place by using a cylindrical pin 11, shown in Fig. 1 B, or by using another fixing method.

Furthermore, in Fig. 3 connecting parts have been arranged to the two second grooves 5 of the lower part of the frame part 1. The connecting parts have been fixed to the second groove 5 with appropriate fixing means, for example with screws and nuts. The connecting parts can be alternatively locked to their places by using a cylindrical pin 7, shown in Fig. 1A, or a spring cotter or another fixing method (not shown in the Figs.). In Fig. 3 gripping elements have been arranged to the connecting parts. In this case, cylinders are used as gripping elements, to which cylinders have been arranged fixing parts 18, 19 of the gripping claws. The total thickness of the fixing part 18, 19 of the gripping claw is here approximately 12.5 mm. The material of the fixing part 18, 19 of the gripping claw is aluminium. The fixing parts of the gripping claws have been fixed to the cylinders for example with hexagonal socket-head screws 16. Furthermore, gripping claws 20 have been fixed to the fixing parts of the gripping claws with appropriate fixing means, for example with a hexagonal socket-head screw 17. One fixing part 18, 19 of gripping claws has two gripping claws 20. The length and the width of the gripping claw 20 are for example in the range of 17-20 mm. Here the length is 17.5 mm and the width is 20 mm. The height of the gripping claw is 7 mm. In the gripping point the width is 4 mm. The material of the gripping claw 20 is titanium nitride (TiN) coated steel. The distance of the upper surface of the gripping claw 20 from the cylinder is 5 mm. In Fig. 3 to each connecting part has been arranged through a cylinder two fixing parts of a gripping claw. Thus, four gripping claws have been arranged to one connecting part. Besides gripping claws and cylinders, alternatively also other electrically, pneumatically or mechanically controlled gripping elements, for example electric linear actuators and/or under-pressure devices (not shown in the Figs.), can be removably fixed to the connecting parts.

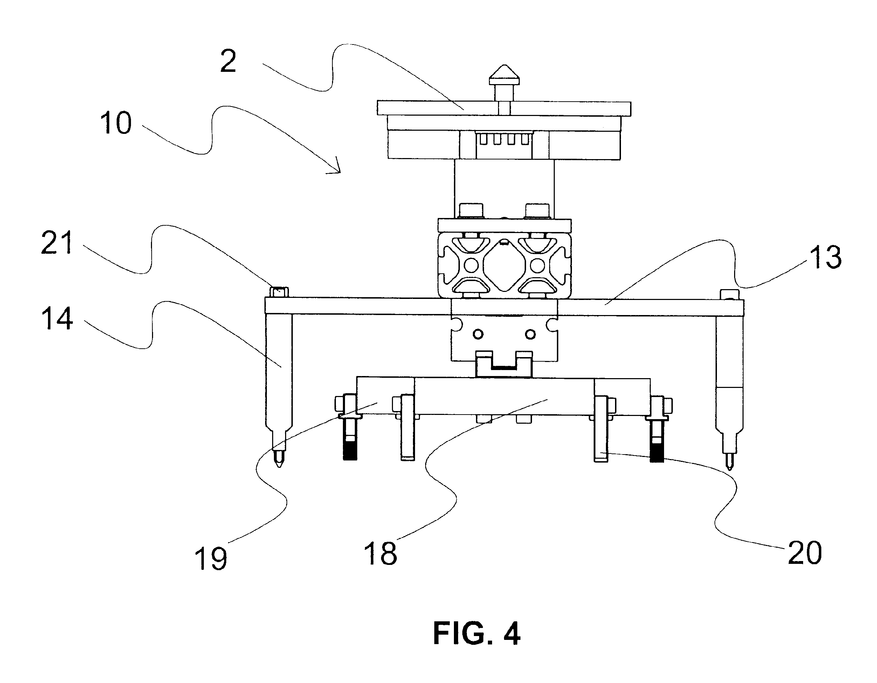

Fig. 4 shows as an example the same gripper according to the third embodiment of the invention seen from the end. The fixing part 13 of the alignment elements has been removably fixed to the connecting part of the gripper 10 with fixing means, for example with screws and nuts. The alignment element 14 has been removably arranged to the fixing part 13 of the alignment element with fixing means 21, for example with a hexagonal socket-head screw. In this case there are two alignment elements, one at each end of the fixing part 13 of the alignment elements. The gripper 10 is aligned to the circuit board or similar boards by alignment elements 14. With alignment elements is ensured an appropriate mechanical gripping to the product. The board to be handled by the gripper 10 has two opposite edges, which determine the size of the product and thus the distance between the alignment elements 14 from each other. The fixing part 13 of the alignment elements is dimensioned according to the size of the product. If electric linear actuators or cylinders are used as gripping elements, conventional gripping claws 20, for example similar to those shown in Fig. 4, can generally be used. The position of the gripping claws is determined by the fixing part 18, 19 of the gripping claws, which is the only part of the gripper to be designed product-specifically. The distance of the gripping claws 20 from each other in the fixing part of the gripping claws is respectively determined by the size of the board to be handled by the gripper. Upon using under pressure gripping no product-specific parts at all are necessarily needed in the gripper 10.

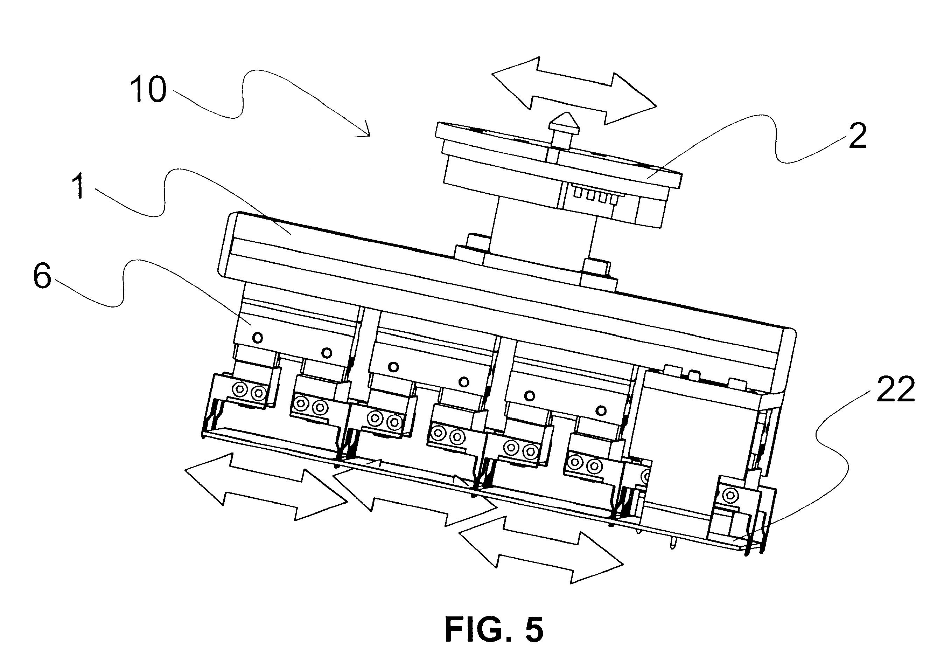

Fig. 5 shows as an example the same gripper according to the third embodiment of the invention. In Fig. 5 is shown the adjustment of the gripper 10 for gripping the product 22. The place of the connecting parts arranged to the frame part 1 can be adjusted by moving the connecting parts in the second groove of the frame part 1 to the direction of the arrows, as shown in Fig. 5. The places of the connecting parts are adjusted by loosening the fixing means 8, shown in Fig. 1A, and by moving the connecting parts exactly to the desired place, after which the fixing means are tightened. Additionally, to the frame part 1 has been arranged a connecting adapter 2, the place of which can be adjusted by moving the connecting adapter in the first groove of the frame part 1 to the direction of the arrows, as shown in Fig. 5. The place of the connecting adapter 2 is adjusted by loosening its screws 9, shown in Fig. 1 A, and nuts 12, shown in Fig. 1 B, and by moving the connecting adapter 2 exactly to the desired place, after which the screws and nuts are tightened. It is possible to fine adjust the distance between the gripping claws by loosening the hexagonal socket-head screws 17, shown in Fig. 3, and by positioning the gripping claw exactly to the desired place, after which the screws are tightened. The fine adjustment of the distance of the gripping claws is possible for example in the range of 0-1 mm.

A typical gripper 10 shown in Fig. 5 comprises four connecting parts, which are positioned one after the other to the same second groove to the desired places in the frame part. Gripping claws have been fixed to the connecting parts through cylinders and fixing parts of the gripping claws. Additionally, alignment means have been arranged to one connecting part. In this case, the product 22 can be handled by the gripper, which product comprises four separate circuit boards or similar boards, which can have various dimensions. Gripping of the product can be secured, if needed, by sensors (not shown in Figs.), for example, for the position of the gripping elements or identifying the product 22. The use of sensors depends, however, on the control mode of the actuator (not shown in Figs.), to which the gripper 10 has been fixed. The control unit of a typical gripper 10 shown in Fig. 5 is in the actuator, to which the gripper is connected by the connecting adapter 2. The control unit (not shown in Figs.) can be for example a computer, which controls the actuator. The gripping elements, for example under-pressure elements, of the gripper are thus controlled through the control unit and the gripping elements get their operation energy from the connected actuator.

It is self-evident to a person skilled in the art that the invention is not limited to the solutions described above, but the inventive idea can be applied in numerous ways within the scope of the claims. For example, the number of connecting parts arranged to the frame part of the gripper has not been limited within the scope of the invention. The size or shape of the frame part of the gripper can vary. The gripping mode of the gripping elements can be different, an electric linear actuator, an under-pressure gripping, an alignment element, a cylinder or the like, in each connecting part of the gripper.

## Claims

1. A gripper (10) for handling circuit boards (22), which gripper comprises a connecting adapter (2) for fixing the gripper to the actuator, a frame part (1), at least one connecting part (3) and at least one gripping element (6), **characterized in that** the frame part (1) further comprises at least one first groove (4) extending from one end of the frame part to its other opposite end for guiding the connecting adapter (2) between the ends of the frame part and for fixing it (2) to its place, and at least one second groove (5) parallel with the first groove for guiding at least one connecting part (3) and at least one gripping element (6) arranged thereto between the ends of the frame part and for fixing at least one connecting part (3) to its place.

2. Gripper according to claim 1, **characterized in that** at least one first groove (4) is located at the opposite side of the frame part (1) in relation to the at least one second groove (5) of the frame part.

3. Gripper according to claim 2, **characterized in that** said first groove (4) and second (5) groove have been arranged opposite to each other.

4. Gripper according to claim 1, **characterized in that** the connecting adapter (2) has been arranged to the first groove (4) of the frame part (1) so that the connecting adapter has been arranged to be moved in the first groove from one end of the frame part to its other opposite end.

5. Gripper according to claim 1, **characterized in that** it comprises at least one connecting part (3), which has been arranged to the second groove (5) of the frame part (1) so that the connecting part has been arranged to be moved in the second groove from one end of the frame part to its other opposite end.

6. Gripper according to claim 1, **characterized in that** it comprises at least two connecting parts (3), which have been arranged to the same second groove (5) of the frame part (1) so that the connecting parts have been arranged to be moved in the same second groove irrespective of each other.

7. Gripper according to claim 1, **characterized in that** to the connecting part (3) has been removably arranged a fixing part (13) of the alignment elements, to which has been removably arranged at least one alignment element (14) for gripping and aligning to the product (22).

8. Gripper according to claim 1, **characterized in that** to the connecting part (3) has been removably arranged a fixing part (13) of the alignment elements, to which has been removably arranged at least two alignment elements (14) for gripping and aligning to the product (22).

9. Gripper according to claim 1, **characterized in that** to the connecting part (3) has been removably arranged electrically, mechanically or pneumatically controlled gripping elements (6).

10. Gripper according to claim 1, **characterized in that** the gripper (10) has been provided with sensors for securing the gripping to the product (22).

11. Gripper according to claim 1, **characterized in that** the frame part (1) is elongated and the shape of its cross section is mainly rectangular.

12. Gripper according to claim 1, **characterized in that** the connecting adapter (2) is a quick change unit to be connected to the actuator.

13. Gripper according to claim 1, **characterized in that** the frame part (1) is of aluminium profile.

14. Method for fixing a connecting part (3) of a gripper (10), which is intended for gripping circuit boards or similar boards (22), to the frame part (1) of the gripper, in which method
- the connecting part (3) is positioned to a desired place of the frame part (1) and
- the connecting part (3) is fixed to the frame part (1) by fixing means,
**characterized in that** upon positioning the connecting part (3) to the desired place
- the connecting part (3) is positioned to the groove located in the frame part (1) and
- the position of the connecting part (3) in relation to the frame part (1) is determined by moving the connecting part in the direction of said groove to the desired place.

15. Method according to claim 14, **characterized in that** to the same groove to the desired places of the frame part (1) are positioned two or more connecting parts (3) one after the other.
